# EUROPEAN PATENT APPLICATION

(11) **EP 1 199 738 A2**
(43) Date of publication of application: **24.04.2002**
(21) Application number: 01124091.8
(22) Date of filing: 10.10.2001
(51) Int. Cl.: H01J 5/02, H01J 5/16, H01J 9/20, H01J 17/16

(54) **Transparent electromagnetic radiation shield/near infrared ray cut material and methods of producing the same**

(30) Priority: 19.10.2000 JP 2000319059; 07.06.2001 JP 2001172039
(71) Applicant: NISSHINBO INDUSTRIES, INC., Chuo-ku, Tokyo (JP)
(72) Inventor: Marutsuka, Toshinori, Nisshinbo Industries, Inc., Chiba-shi, Chiba (JP)
(74) Representative: Leifert, Elmar, Dr.

(57) **Abstract**

A transparent electromagnetic radiation shielding/near infrared cutting material and a method of producing are disclosed. The material comprises an identical and matched mesh-pattern transparent electromagnetic radiation shield layer having at least one of black layer/metallic layer or a metallic layer/black layer or a black layer/metallic layer/black layer; and a transparent near infrared cut layer. The transparent electromagnetic radiation shield layer and the transparent near infrared cut layer being laminated with a contact therebetween on a transparent base material.

## Description

### BACKGROUND OF THE INVENTION

### 1. Field of the Invention

This invention relates to a transparent electromagnetic radiation shielding/near infrared cutting material and methods of producing the same. More particularly, this invention relates to a transparent electromagnetic radiation shielding/near infrared cutting material having excellent electromagnetic radiation shielding and near infrared cutting capabilities as well as excellent transparency and visibility, and suitable for use for displays, especially for a large plasma display panel (PDP), and to methods of effectively producing the transparent electromagnetic radiation shielding/near infrared cutting material.

### 2. Discussion of the Related Art

It has been said that a large amount of harmful electromagnetic radiations of non-ionizing radiations such as micro radiations and radio waves are generated from the surfaces of various computer displays of office automation devices and factory automation devices or displays of game devices or TVs. In recent years, the influence of the electromagnetic radiations on human health has been noted, and the hindrance to other devices caused by the electromagnetic radiation has become an issue.

Recently, a great deal of attention has been given to a plasma display panel (PDP), which is a luminous-type and flat-type display, as a large display having excellent visibility. In such PDPs, intensity of electromagnetic radiation leaking from the front surface of the display is so strong compared to other display panels such as conventional cold-cathode ray tube (CRT) and liquid crystal display (LCD) panels that PDPs are strongly required to have a much higher electromagnetic radiation shielding capability. In addition, in PDPs, near infrared rays originated from luminescence of inert gases such as Ne gas and Xe gas in the cells are emitted from the front surface. Since the wavelength of such near infrared ray is similar to a driving wavelength of a remote controller of various electric appliances, the near infrared ray causes malfunction of the electric appliances. Therefore, it is also strongly required to have a capability to shield such near infrared ray.

Materials used for placement in front of such display panels are required to have excellent visibility (optical transmittance), high clarity and a wide viewing angle in addition to high electromagnetic radiation shielding capability and high near infrared cutting capability.

Proposed materials having visibility, transparency, optical transparency as well as an electromagnetic radiation shielding capability or both of electromagnetic radiation shielding and near infrared cutting capabilities include, for example, (1) an electromagnetic radiation shield wind glass in which a transparent conductive thin film composed of an ITO (indium tin oxide), etc. and a thermal linear reflection layer composed of a laminated article of optical thin films such as TiO₂ and SiO₂ are laminated on a glass substrate (Japanese Patent Application Laid-Open No. 60-27623 (JP 60-27623)) and (2) an electromagnetic radiation shield transparent sheet (JP 1-170098) in which a transparent conductive film and a conductive grid pattern are formed on a transparent plate.

However, the electromagnetic radiation shield wind glass of (1) above has problems. Specifically, electromagnetic radiation shielding performance is extremely low (in a transparent conductive thin film, electromagnetic radiation shielding performance becomes low in an attempt to obtain a high optical transmittance) and clarity is also poor (color and luster are inappropriate). Therefore, such electromagnetic radiation shield wind glass cannot be used for displays that require high near infrared cutting performance, electromagnetic radiation shielding performance, visibility (optical transmittance) and clarity such as PDPs.

Also, the electromagnetic radiation shield transparent sheet of (2) above, both of electromagnetic radiation shielding performance and near infrared cutting performance are extremely low (a little improvement of electromagnetic radiation shielding performance may be seen at a low frequency (long wavelength) but is hardly seen at a frequency of 500 MHz). Further, clarity is extremely poor (grid patterns are visibly seen and obstruct the view) so that it cannot also be used for displays such as PDPs.

### SUMMARY OF THE INVENTION

Under the circumstances with such drawbacks of the prior art, it is an object of the present invention to provide a transparent electromagnetic radiation shielding/near infrared cutting material having an excellent electromagnetic radiation shielding capability and a near infrared cutting capability as well as excellent visibility and clarity for displays, especially for a large plasma display panel (PDP).

As a result of a number of diligent studies and their continuous efforts in developing such transparent electromagnetic radiation shielding/near infrared cutting material having excellent capabilities as mentioned above, the inventors have found that a material prepared by laminating a transparent electromagnetic radiation shield layer having a particular structure and a transparent near infrared cut layer with a contact therebetween on a transparent base material successfully meets the requirements for the transparent electromagnetic radiation shielding/near infrared cutting material. Further, the inventors have also found that such material can be easily produced by using a particular process. The present invention has been accomplished based on these findings.

Specifically, the present invention provides:
(1) a transparent electromagnetic radiation shielding/near infrared cutting material in which on a transparent base material, at least (A) a transparent electromagnetic radiation shield layer composed of an identical and matched mesh-pattern of a black layer/metallic layer or a metallic layer/black layer or a black layer/metallic layer/black layer and (B) a transparent near infrared cut layer are laminated with a contact therebetween;
(2) a method of producing a transparent electromagnetic radiation shielding/near infrared cutting material comprising the steps of (a) forming a black layer/metallic layer or a metallic layer/black layer or a black layer/metallic layer/black layer on a transparent base material by dry plating; forming a mesh-like resist pattern layer on the black layer/metallic layer or a metallic layer/black layer or a black layer/metallic layer/black layer; conducting sandblasting and/or etching treatment using the mash-like resist pattern as a protection layer so that the black layer/metallic layer or metallic layer/black layer or black layer/metallic layer/black layer is patterned to form a mesh pattern matched to that of the resist pattern layer; pealing off the resist pattern; and (b) laminating a transparent metal oxide layer or a transparent metal sulfide layer and a metallic thin film layer by dry plating one after the other in order so that the outer most layer is the transparent metal oxide layer or the transparent metal sulfide layer (herein after called Method I of the present invention);
(3) a method of producing a transparent electromagnetic radiation shielding/near infrared cutting material comprising the steps of (a) forming a black layer/metallic layer or a metallic layer/black layer or a black layer/metallic layer/black layer on a transparent base material by dry plating; forming a mesh-like resist pattern layer on the black layer/metallic layer or metallic layer/black layer or black layer/metallic layer/black layer; conducting sandblasting and/or etching treatment using the mash-like pattern as a protection layer so that the black layer/metallic layer or metallic layer/black layer or black layer/metallic layer/black layer is patterned to form a mesh pattern matched to that of the resist pattern layer; peeling off the resist pattern; and (b') laminating two types of transparent inorganic layers having a deferent refractive index one after the other by dry plating (herein after called Method II of the present invention);
(4) a method of producing a transparent electromagnetic radiation shielding/near infrared cutting material comprising the steps of (a') forming a resist pattern layer on a transparent base material so as mesh-like portions of the transparent base material to be exposed; forming a black layer/metallic layer or a metallic layer/black layer or a black layer/metallic layer/black layer on the resist pattern layer and the exposed portions of the transparent base material by dry plating; peeling off the resist pattern layer so that only portions of the black layer/metallic layer or metallic layer/black layer or black layer/metallic layer/black layer formed on the surface of the resist layer are removed; and (b) laminating a transparent metal oxide layer or a transparent metal sulfide layer and a metallic thin film layer by dry plating one after the other in order so that the outer most layer is the transparent metal oxide layer or the transparent metal sulfide layer (herein after called Method III of the present invention); and
(5) a method of producing a transparent electromagnetic radiation shielding/near infrared cutting material comprising the steps of (a') forming a resist pattern layer on a transparent base material so as mesh-like portions of the transparent base material to be exposed; forming a black layer/metallic layer or a metallic layer/black layer or a black layer/metallic layer/black layer on the resist pattern layer and the exposed portions of the transparent base material by dry plating; peeling off the resist pattern layer so that only portions of the black layer/metallic layer or metallic layer/black layer or black layer/metallic layer/black layer formed on the surface of the resist layer are removed; and (b') laminating two types of transparent inorganic layers having a different refractive index one after the other by dry plating (herein after called Method IV of the present invention).

### DETAILED DESCRIPTION OF THE PREFERRED EMBODIMENTS

A transparent electromagnetic radiation shielding/near infrared cutting material of the present invention (herein after it may simply be called a material of the present invention for short) has such a structure that on a transparent base material, at least (A) a transparent electromagnetic radiation shield layer and (B) a transparent near infrared cut layer are laminated with a contact therebetween.

The transparent base materials used in the present invention are not particularly limited insofar they have high transparency, strength and heat-resistance, and therefore various materials can be used. For example, glass, tempered glass and a plastic made of olefine-maleimide copolymer, norbornene resins, acyl resins, polycarbonate, polyethylene terephthalate, tri-acetate cellulose, etc. can be used. Among these, tempered glass, olefine-maleimide copolymer, norbornene resins are preferably used since they are excellent in strength and heat-resistance.

When using a transparent base material made of plastic, the plastic should preferably have a thermal-deformation temperature of 140-360 °C, a coefficient of thermal linear expansion of not greater than 6.2×10⁻⁵ cm/cm·°C, a pencil hardness of not less than 2H, a bending strength of 120-200 N/mm², a modulus of elasticity in bending of 3,000-5,000 N/mm² and a tensile strength of 70-120 N/mm². Such plastic can be used in a wide range of environments since it is resistant to high-temperature warping and scratching.

The plastic preferably has an optical transmittance of not less than 90%, an Abbe's number of 50-70 and a photoelasticity constant (glass region) of an absolute value of not greater than 10×10⁻⁸ cm²/N. Such plastic exhibits high transparency (bright) and little birefringence (less likely to produce a double image), and therefore does not degrade the image quality, brightness, etc. of the display.

The type of the transparent base material used in this invention is not particularly limited and can be any type such as film-type, sheet-type, plate-type, etc. The thickness of the transparent base material is normally selected in the range of 0.05-10 mm. The thickness of less than 0.05 mm is not preferable as it becomes difficult to handle. The thickness of greater than 10 mm is also not preferable as it becomes heavy. The preferable thickness is 0.1-5 mm.

The transparent electromagnetic radiation shield layer ((A) layer) used in the material of the present invention is composed of an identical and matched mesh-pattern of a black layer/metallic layer or metallic layer/black layer or black layer/metallic layer/black layer. The metallic layer in the transparent electromagnetic radiation shield layer ((A) layer) is not limited insofar as it has electromagnetic radiation shielding capability and also mesh patterning can be carried out. A metal having a resistivity of not greater than 1.0×10⁻⁴ Ω·cm, such as copper, nickel, gold, silver, etc., is preferable. Among these, copper is particularly preferable from the points of view of electromagnetic radiation shielding capability (resistivity), handling ease, cost efficiency, etc. Generally, metallic layer has a high conductivity (law resistivity) and exhibits higher shielding performance with a thicker layer and high mesh patterning capability with a thinner layer. When a resistivity exceeds 1.0×10⁻⁴ Ω·cm, it is difficult to obtain both high electromagnetic radiation shielding performance and mesh patterning capability at the same time.

This metallic layer can be formed by one of or a combination of two or more of the methods of dry plating such as ion plating, spattering and vapor deposition, electroless plating or electroplating. A metallic foil can be also used herein. Among these methods, a dry plating method is particularly preferable. The thickness of the metallic layer is generally selected from the range of 0.1-35 µm. When a thickness is less than 0.1 µm, electromagnetic radiation shielding capability may be insufficient. A thickness exceeding 35 µm makes mesh patterning difficult to be carried out. Preferred thickness of the metallic layer is 0.2-1.0 µm in a dry plating method, 0.5-3.0 µm in a plating method and 9-18 µm when using a metallic foil.

The black layer is used to provide good visibility and is composed of a single layer of or a combination of two or more layers of a black resin layer, a black inorganic layer and a black metal oxide layer (excluding black layers formed by oxidation or sulfurization of the surface layer of the metallic layer).

The black resin layer above can be a resin layer containing a black pigment or black dye. The black pigment can be a substance that exhibits black such as reduced metallic particles, metal oxide particles, carbon particles, etc. The reduced metal particles can be colloid particles contained in a reduced metal colloid dispersion or reduced metal powder particles obtained from the metal colloid dispersion. They are not particularly limited as regards type of metal or grain size insofar as they are uniformly dispersible in a coating liquid (coating). To obtain high dispersion stability, the grain size of the reducing metal particle is preferably not greater than 1 µm. Such reduced metallic particle preferably have high stability with respect to the atmosphere and moisture.

Specific examples of usable reduced metal particles include particles of metals belonging to Group Ib or Group VIII of the Periodic Table of the Elements (Cu, Ni, Co, Ph, Pd, etc.), with reduced Ni colloid particles and reduced Ni powder obtained therefrom being particularly preferable. The reduced metal colloid particles can be produced by the methods described in Japanese Patent Application Laid-Open No. 1-315334. Specifically, a colloid dispersion can be obtained by reducing a salt of the metal in a mixed solution consisting of a lower alcohol and an aprotic polar compound.

The metallic oxide particles are not particularly limited as regards type of metal or grain size insofar as they are uniformly dispersible in the coating liquid (coating). To obtain high dispersion stability, the grain size is preferably not greater than 1 µm. Preferable examples include particles of oxides of metals belonging to Group Ib or Group VIII of the Periodic Table of the Elements such as iron, copper, nickel, cobalt and palladium.

The carbon particles, similar to the reduced metallic particles or the metallic oxide particles, are not particularly limited as regards type of metal or grain size insofar as they are uniformly dispersible in the coating liquid (coating). To obtain high dispersion stability, the grain size is preferably not greater than 1 µm. Preferable examples include carbon black, natural or artificial graphite particles, etc.

Usable black dyes are not limited as regards type or content insofar as they are uniformly dispersible or can be dissolved in the coating. Such black dyes preferably have high stability with respect to the atmosphere, moisture, light and heat in the coating. Preferable examples include acid dye, disperse dye, direct dye, reactive dye, sulfur dye, sulfur vat dye, etc. Among these, acid dye is particularly preferable.

The content of these black pigment and black dye in the black resin is preferably 1-80 weight %, more preferably 5-70 weight %. When the content is less than 1 weight %, the degree of blackness of the black layer may be insufficient. A content exceeding 80 weight % may degrade the coating property.

The resins used in the black resin layer are not limited as regards type insofar as they can dissolve or be used to prepare a high dispersion of the black pigment or black dye in a form of a resin solution (black coating liquid) containing black pigments or black dyes dispersed or dissolved therein and in a form of a coating (black resin layer) obtained by applying and drying the black coating liquid. Further, they are not limited as regards transparency, color, etc. insofar as they do not impair the blackness of the black resin layer (degree of blackness of the black layer).

Preferable examples include polyvinylacetate, acrylic, polyester, cellulose, polyimide, polycarbonate, polycarbodiimide, epoxy, polystyrene, gelatin types, etc.

The black resin layer used herein is a black layer whose components are all resins except for such components as black pigment and black dye (matrix or binder). Additives such as plasticizer and surfactant can be added insofar as they do not impair the black resin layer property.

The black resin layer containing a large amount of black pigment such as carbon particles having conductivity (soot, carbon black or graphite, etc.) and reduced metallic colloid particles (or reduced metallic power obtained from the reduced metallic colloid particles) has conductivity and also is black, and therefore direct electroplating can be carried out. The conductivity expressed as surface resistance of the black resin layer for this direct electroplating is preferably not greater than 10 Ω, more preferably not greater than 5 Ω. When the conductivity expressed as surface resistance exceeds 10 Ω, plating deposition may be non-uniform.

In the present invention, when forming a black resin layer, an India ink having carbon particles dispersed and contained in a resin solution (in a dried coating, the carbon content: about 90 weight %) a conductive carbon coating material in a resin solution or a resin solution having palladium colloid particles, etc. dispersed and contained therein can preferably be used.

When reduced metallic colloid particles are used, a black resin layer capable of direct electroplating (a black resin layer having conductivity) can be formed by forming a transparent resin layer and then dipping the transparent resin layer in the reduced metallic colloid particle dispersion (penetrating and adsorbing the reduced metallic colloid particles into the transparent resin layer). The content of the reduced metallic colloid particles has an inclination in a direction of the thickness of the resin layer (the greatest at the surface). This is especially effective to obtain high electroplating deposition and adherence.

Treatment conditions vary depending on type or concentration of metal in the reduced metallic colloid dispersion, grain size of colloid particles, etc. When a standard palladium colloid dispersion sold on the market (containing about 1 weight % of Pd as PdCl₂) is used, the product is soaked for 1-60 minutes at a room temperature, preferably 5-30 minutes. When a treatment time is less than 1 minute, blackness and conductivity may be insufficient (plating deposition is not uniform). When a treatment time exceeds 60 minutes, little change in blackness and conductivity is observed.

In the present invention, the solvent for preparing the resin solution for the black coating liquid can be of any type insofar as it can dissolve or be used to prepare a dispersion of resin, black pigment or black dye.

Preferable solvents include a single solvent of or a mixed solvent of water, methanol, ethanol, chloroform, methylene chloride, trichloroethylene, tetrachloroethylene, benzene, toluene, xylene, acetone, ethyl acetate, dimethylformamide, dimethylsulfoxide, dimethylacetamide and N-methylpyrrolidone. A solvent appropriate for the combination of resin, black pigment or black dye is selected.

The solution containing the resin, black pigment or black dye (black coating liquid) is applied to the transparent base material or metallic layer and dried to form a coating containing the black pigment or black dye (black resin layer). As to the application of the solution, a conventional method such as brush coating, spray coating, dipping, roller coating, calendar coating, spin coating, bar coating, screen printing, etc. that is appropriate for the shape of the transparent base material or metallic layer is selected.

The conditions (temperature, time, etc.) for coating formation are determined based on type and concentration of the resin, coating thickness and the like. The nonvolatile content of the solution is normally 0.05-20 wt %. The thickness of the dried coating is 0.5-50 µm, preferably 1-25 µm. No blackness is observed and clarity may be poor at a thickness of less than 0.5 µm. Viewing angle may become narrow at a thickness exceeding 50 µm.

The black inorganic layer is an inorganic layer containing black pigments. Usable black pigments are not limited as regards type and grain size insofar as they are uniformly dispersible in the black inorganic layer. To obtain high dispersion stability grain size is preferably not greater than 1 µm. Those black pigments listed above for the black resin layer can be similarly used.

The content of the black pigment in the black inorganic layer is preferably 1-50 weight %, more preferably 5-25 weight %. Blackness of the black layer may be insufficient at a content of less than 1 weight %. Viewing angle may become narrow at a content exceeding 50 weight %.

The black inorganic layer can be formed by preparing a liquid-like or past-like black coating liquid prepared from inorganic particles containing black pigments and/or a mixture of black pigments and inorganic particles with a liquid-like material, applying and drying the black coating liquid to form a coating, conducting heat treatment, if necessary, and molding or sintering or binding to bond the particle.

Usable inorganic particles are not limited as regards type, grain size, transparency, color, etc. insofar as they can be uniformly dispersed in the black coating liquid and do not impair blackness of the black layer. To obtain high dispersion stability, the grain size is preferably not greater than 1 µm. The inorganic particle is mainly used for forming a matrix; however, it is also used to increase viscosity or thixotropy of the black coating liquid.

Preferable examples include a single component type or a multicomponent type oxide such as glasses including glass silicate (SiO₂) (within parentheses show a major component), alkali glass silicate (Na₂O-SiO₂), soda lime glass (NaO-CaO-SiO₂), potash lime glass (K₂O-CaO-SiO₂), lead glass (K₂O-PbO-SiO₂), barium glass (BaO-B₂O₃-SiO₂), borosilicate glass (Na₂O-B₂O₃-SiO₂), etc. and Al₂O₃, TiO₂, ZrO₂, MgO, etc.; carbides including SiC, WC, TiC, TaC, ZrC, B₄O, etc.; nitrides including Si₃N₄, BN, TiN, ZrN, AlN, etc.; acid nitrides including sialon, etc. Preferably, one of or a combination of two or more of these inorganic particles are used. Among these, soda lime glass is preferably used.

The liquid-like material may be a solvent only, however, a material including a solvent and a binder that remains as a solid substance after the black inorganic layer is formed is normally used.

The binder is a resin being dissolved in the liquid-like material or a resin particle or an inorganic particle being dispersed in the liquid-like material. The inorganic particle for the binder is not distinguished from an inorganic particle used for a matrix other except from the point of view that it has a low fusion point and a lower content compared to those of the inorganic particle used for a matrix.

Usable resins for the binder are not limited as regards type insofar as they can prepare a good dispersion of black pigments and inorganic particles in a form of a black coating liquid and a black inorganic layer. Those resins listed as examples of resins used for a matrix or binder in the black resin layer case above can similarly be used. To obtain the properties (hardness, etc.) and processability of inorganic layer, one with a content of not greater than 10 weight % in the black inorganic layer is normally used.

While the black resin layer discussed above has a high coating formation capability (especially in a form of a thin film) and a low patterning capability (more soft than black inorganic layer) when using the blast method, etc., the black inorganic layer has opposite capabilities and therefore it has different characteristics from those of the black resin layer.

Thus, these layers can be selectively used depending on required mesh pattern, line width/line interval (aperture width), viewing angle, processing accuracy, processing cost, etc.

Usable solvents are not limited as regards type insofar as they can dissolve or prepare dispersion of black pigments, inorganic particles and binders. These solvents listed as examples used in the black resin layer case above can similarly be used.

The other conditions including the nonvolatile content of the black coating liquid, the thickness and the coating method of the black inorganic layer, etc. are similar to those used in the black resin layer case above.

The black inorganic layer used herein is a black layer having an inorganic content exceeding 50 weight % of its component excluding black pigments (matrix or binder). The components other than black pigments are distinguished as a matrix when they are defined as a "sea" part in the "island-sea structure" and as a binder when they are not defined as a matrix regardless their contents in the black inorganic layer. The additives including plasticizer, surfactant, etc. can be added insofar as they do not impair the black resin layer property.

The thickness of the black inorganic layer is normally 0.5-50 µm, preferably 1-25 µm. No blackness is observed and clarity may be insufficient at a thickness of less than 0.5 µm. Viewing angle may become narrow at a thickness exceeding 50 µm.

Further, the black metal oxide (which is not used with a meaning of "an oxide of a black metal" but rather "metal oxide in black") layers is, in a similar way to that of the black resin layer and the black inorganic layer, a layer that is added (a laminated layer) on the metallic layer as discussed above and is not a blackened layer as a result of oxidation treatment to a part of the metallic layer (surface layer).

Usable black metal oxides can be of any type, thickness, producing method, etc. insofar as they have sufficient blackness and also mesh patterning can be carried out. One of or a combination of two or more of oxides of metal such as copper, nickel, cobalt, iron, palladium, platinum, indium, tin, titanium, chromium, etc. are appropriate. Among these, copper oxide and tin oxide are preferable in view of mesh patterning capability and cost efficiency.

Although some metal oxide layers (many of them have insulating capability) have low conductivity (tin oxide, etc.), a good electromagnetic radiation shielding capability is difficult to obtain and therefore they are obviously distinguished from metallic layers from the points of view of purpose and conductivity.

The thickness of the black metal oxide layer is normally 0.01-1 µm, preferably 0.05-0.5 µm. At a thickness of less then 0.01 µm, many pinholes may be observed and blackness may be insufficient. At a thickness exceeding 1 µm, treatment cost increases and thus it is disadvantageous in cost efficiency.

The black metal oxide layer is formed by one of or a combination of two or more of the methods of vapor deposition, spattering, ion plating, electroless plating, electroplating, etc.

When laminating the black layer on the transparent base material via an intervening transparent adhesive, usable transparent adhesives include polyvinylacetate, acrylic, polyester, epoxy, cellulose, vinylacetate type resins. The thickness of the adhesive layer is generally not less than 1 µm, preferably about 5-500 µm.

The transparent electromagnetic radiation shield layer ((A) layer) of the present invention preferably has a degree of blackness, expressed as optical density, of not less than 2.9 (angle of incidence of 7°; assuming no specular reflection). When the optical density is less than 2.9, clarity may be insufficient. For an independent black layer, however, the degree of blackness does not need to be not less than 2.9 (a sufficient degree of blackness is often observed when metallic layer is laminated).

In the transparent electromagnetic radiation shield layer ((A) layer), each layer should be an identical and matched mesh pattern. The pattern is not particularly limited and any pattern can be appropriately selected from, for example, grid (tetragonal), triangular, polygonal having not less than five angles, circular, elliptical, etc.

The line width is normally less than 1 mm, preferably not greater than 50 µm, more preferably not greater than 25 µm. The line width is automatically determined when the line interval and aperture ration are determined. The lower limit of the line width is not particularly limited, however, it is normally about 2 µm considering patterning capability, etc. The line interval is normally less than 7 mm, preferably not greater than 200 µm, more preferably not greater than 100 µm. The lower limit of the line interval is not limited insofar as patterning process can be carried out, however, it is normally about 10 µm considering the line width and aperture ratio, etc.

The thickness of the line is preferably not greater than 50 µm, more preferably not greater than 25 µm. The aspect ratio of line thickness/line width is set not greater than 0.5 (since the higher the aspect ratio is, the lower patterning capability and the narrower viewing angle are observed) considering the patterning capability, viewing angle, etc. The lower limit is not particularly limited, however, it is normally about 0.1 µm. The aperture ration is normally not less than 64 %, preferably not less than 81 %.

Such identical and matched mesh-pattern transparent electromagnetic radiation shield layer can effectively be produced by, for example, the producing method of the present invention as discussed below.

The materials for the transparent near infrared cut layer ((B) layer) of the present invention include: (B-1) a material having such a structure that a transparent metal oxide layer or transparent metal sulfide layer and a metallic thin film layer are laminated one after the other in an order so that the outer most layer is the transparent metal oxide layer or transparent metal sulfide layer, the material being composed of an odd number of layers and not less than three layers (however, the metallic layer can be a layer having one type of metal (single layer) or an amorphous layer having two or more types of metal (single layer) or multiple layers); (B-2) a material being so constituted that two types of transparent inorganic layers having a different refractive index are laminated one after the other in order, preferably the material being composed of an even number of layers and not less than six layers; or (B-3) a resin coating containing coloring agents that absorb near infrared rays. The resin coating can produce a high image quality (color definition, etc.) and color grain by adding a coloring agent that absorbs an orange light (550-620 nm including neon light), coloring agents for color adjustment, etc.

As to the materials in the present invention, these transparent near infrared cut layers ((B) layers) are formed on the entire surface of the transparent base material including the surface of the mesh-pattern transparent electromagnetic radiation shield layer ((A) layer).

The metals composing the metallic thin film layer used in the (B-1) layer above has a resistivity of not greater than 2.5 × 10⁻⁶ Ω·cm. Preferable examples include gold, silver, copper or an amorphous of these metals. The thickness of the metallic thin film is normally 5-40 nm, preferably 10-20 nm. Preferable examples of the metal oxides composing the transparent metal oxide layer include titanium oxide, zinc oxide, indium oxide, tin oxide, ATO (antimony tin oxide), ITO (indium tin oxide), etc. Preferable examples of the metal sulfides composing the transparent metal sulfide layer include zinc sulfide, etc. The thickness of the transparent metal oxide layer or transparent metal sulfide layer is normally 20-60 nm, preferably 30-40 nm. The (B-1) layer is composed of an odd number of layers and not less than three layers. The thickness of the whole transparent metal oxide layer or transparent metal sulfide layer ((B) layer) is selected, for example, in the range of 45-160 nm for three layers, preferably 70-100 nm.

The (B-1) layer above can be formed, for example, by a dry plating method such as vapor deposition, spattering, ion plating, etc.

The (B-2) layer is a material being so constituted that two types of transparent inorganic layers having a different refractive index are laminated one after the other. Examples of the inorganic compound composing the transparent inorganic layer include inorganic compounds having a low refractive index such as magnesium fluoride, silicon dioxide, etc. and inorganic compounds having a high refractive index such as titanium oxide, tantalite oxide, tin oxide, indium oxide, zirconium oxide, zinc oxide, etc. The (B-2) layer is formed by appropriately combining the transparent inorganic layer composed of the above-mentioned inorganic compound having a low refractive index and the transparent inorganic layer composed of the inorganic compound having a high refractive index, and laminating them one after the other. Especially, a combination of the transparent inorganic layer composed of silicon dioxide and the transparent inorganic layer composed of titanium oxide is preferable since an excellent transparency and a big difference in refractive index can be obtained.

The (B-2) layer preferably is composed of an even number of layers and not less than six layers. The layer at the bottom and the layer at the top preferably have λ/8 or λ/4, and the other layers at therebetween preferably have λ/4. n represents a refractive index, d represents a thickness, λ, represents wavelength of the near infrared ray that needs to be cut. The (B-2) layer can be formed by, for example, a dry plating method such as vapor deposition, spattering, ion plating, etc.

Further, examples of the coloring agents that absorb near infrared rays used in the (B-3) layer include phthalocyanie, naphthalocyanine, diimonium, dithiol metal complex, azo compound, polymethyne, anthraquinone type coloring agents. Examples of the coloring agents for color adjustment include phthalocyanine dye/pigment, etc. Examples of the coloring agents that absorb an orange light include cyanine dye, squalylium dye, azo methyne dye, xanthene dye, oxonol dye, azo dye, etc.

The resins containing these coloring agents that absorb near infrared rays are not particularly limited insofar as they do not impair the transparency (visible light transmittance) of the near infrared cut layer. Those resins listed as examples in the discussion of the black resin layer in the (A) layer above can similarly be used.

The formation of the (B-3) layer can be carried out by preparing a coating liquid containing the above-mentioned coloring agents that absorb near infrared rays and resins; applying the coating liquid by a normal method such as brush coating, spray coating, dipping, roller coating, calendar coating, spin coating, bar coating, screen printing, etc.; and drying the coating liquid. The solvents used for preparing the coating liquid are not particularly limited insofar as they can dissolve and disperse the coloring agents and resins. Preferable examples include a single or a mixed solvent of water, methanol, ethanol, chloroform, methylene chloride, trichloroethylene, tetrachloroethylene, benzene, toluene, xylene, acetone, ethyl acetate, dimethylformamide, dimethylsulfoxide, dimethylacetoamide, N-methylpyrrolidone, etc.

The thickness of the (B-3) layer formed as described above is normally 1-50 µm, preferably 5-25 µm.

In the present invention, the above-discussed (B-1) layer and (B-2) layer are especially preferable for the transparent near infrared cut layer from the point of view that excellent weatherproof performance (long life) and dry plating capability can be obtained.

In the materials of the present invention, the transparent electromagnetic radiation shield layer ((A) layer) and the transparent near infrared cut layer ((B) layer) should be laminated with a contact therebetween. The order of lamination is not particularly limited; however, a preferable material is one that is so constituted that the (A) layer and the (B) layer are laminated on the same surface as that of the transparent base material by dry plating in order with a contact therebetween.

The transparent electromagnetic radiation shielding/near infrared cutting materials of the present invention preferably have a near infrared transmittance of not greater than 20 %, an optical transmittance of not less than 65 % and a shielding performance of not less than 40 dB (30-1,000 MHz) (not less than 50 dB at 500 MHz). An optical transmittance of less than 65 % is too dark. A shielding performance of less than 40 dB (30-1,000 MHz) or a near infrared transmittance exceeding 20 % is not sufficient for practical applications.

When the materials of the present invention are used for displays such as PDPs, the function layers excluding the (A) layer and the (B) layer, such as antireflection (AR) layer, antiglare (AG) layer, orange light (including neon light) cut layer, color adjustment layer, hard coating layer, antifouling layer, etc., can appropriately be laminated as desired insofar as they do not impair the effect of the present invention. These function layers can be laminated with a contact therebetween in a similar way to that in the (A) layer and the (B) layer, or they can be laminated with an AR film (a film with an AR layer being formed on a transparent film) or an AG film (a film with an AG layer being formed on a transparent film) via an intervening adhesive, or they can be laminated on the surface of the opposite side of the laminated surface of the (A) layer and the (B) layer.

In the present invention, a transparent electromagnetic radiation shielding/near infrared cutting panel can be fabricated by laminating transparent electromagnetic radiation shielding/near infrared cutting materials using a transparent film as a transparent base material to a display panel or a transparent base plate via an intervening transparent adhesive if necessary. The transparent film is preferably one that is constituted as a continuous web that can be continuously processed into a roll. Examples of such films include plastic films having a thickness in the approximate range of 50-300 µm made of polyethylene terephthalate (PET), polyimide (PI), polyethersulfone (PES), polyether-etherketone (PEEK), polycarbonate (PC), polypropylene (PP), polyamide, acrylic resin, cellulose propionate (CP) and cellulose acetate (CA).

Next, there are four methods as to a method of producing the transparent electromagnetic radiation shielding/near infrared cutting materials of the present invention: Methods I, II, III and IV as described below. Each method is now explained.

### Method I

In this method, the transparent electromagnetic radiation shielding/near infrared cutting materials are produced by carrying out the (a) process and the (b) process as discussed below.

In (a) process, first, a black layer/metallic layer or a metallic layer/black layer or a black layer/metallic layer/black layer is formed on a transparent base material by dry plating and a mesh resist pattern layer is formed thereon. The formation of the resist pattern layer is carried out by a conventional method such as printing, photolithography, etc.

Next, using the resist pattern layer as a protection film, sandblasting and/or etching treatment is carried out to remove non-resist portions so that the black layer/metallic layer or metallic layer/black layer or black layer/metallic layer/black layer is patterned to form a mesh pattern that is matched to that of the resist pattern layer. Finally, the resist pattern layer is peeled off and removed by soaking in a peeling solution such as alkali aqueous solution and/or by spraying the peeling solution. The conditions of sandblasting or etching treatment are not particularly limited and are appropriately selected depending on type of the black layer and metallic layer. When sandblasting is carried out, the non-resist portions of the transparent base material is roughened (whitened) and thus it is preferable to coat the product with a transparent resin before the resist pattern layer is peeled off. Thereby a mesh-pattern transparent electromagnetic radiation shield layer ((A) layer) is formed.

Next, in (b) process, a transparent metal oxide layer or a transparent metal sulfide layer and a metallic thin film layer are laminated on the entire surface of a transparent base material or a coating resin including the surface of the (A) layer by dry plating one after the other so that the outer most layer is the transparent metal oxide layer or transparent metal sulfide layer to form a transparent near infrared cut layer ((B) layer). Thereby, the aimed transparent electromagnetic radiation shielding/near infrared cutting material is obtained.

### Method II

In this method after the (a) process is carried out in the same manner as in Method I, (b') process as described below is carried out to fabricate a transparent electromagnetic radiation shielding/near infrared cutting material.

In (b') process, two types of transparent inorganic layers having a different refractive index are formed on the entire surface of a transparent base material or a coating resin including the surface of the (A) layer formed in the same manner as in the (a) process above by dry plating to form a transparent infrared cut layer ((B) layer).

### Method III

In this method, after (a') process as described below, the (b) process is carried out in the same manner as in Method I to fabricate a transparent electromagnetic radiation shielding/near infrared cutting materials.

In (a') process, first, on a transparent base material, a resist pattern layer is formed in the same manner as in Method I so as mesh portions of the transparent base material to be exposed. Next, a black layer/metallic layer or a metallic layer/black layer or a black layer/metallic layer/black layer is formed thereon by dry plating. Then, the resist pattern layer is peeled off and thereby only portions of the black layer/metallic layer or metallic layer/black layer or black layer/metallic layer/black layer formed on the surface of the resist layer is removed to form a mesh-pattern transparent electromagnetic radiation shield layer (liftoff method). The conditions and method of peeling the resist pattern are the same as those of Method I above.

In the (a') process, a desired mesh-pattern transparent electromagnetic radiation shield layer is formed by simply peeling off the resist pattern layer with portions of the black layer or metallic layer formed thereon so that sandblasting or etching treatment becomes unnecessary and thus the number of processing steps are dramatically reduced. As a result, processing accuracy and yield increase compared to the (a) process.

However, since the resist pattern layer is peeled off and removed with the layers formed thereon, the thickness of the layer formed on the resist pattern layer is preferably not greater than 5 µm, more preferably not greater than 3 µm. A thickness exceeding 5 µm degrades processability (a portion of the non-resist portions of the layer composed of the black layer or metallic layer on transparent base material may be peeled off). The lower limit of the thickness is not particularly limited as far as processing is concerned and it is determined depending on required electromagnetic radiation shielding performance.

Then, in (b) process, a transparent near infrared cut layer ((B) layer) is formed in the same manner as in Method I on the entire surface of the transparent base material including the surface of the (A) layer formed by the (a') process.

Thereby the aimed transparent electromagnetic radiation shielding/near infrared cutting material is obtained.

### Method IV

In this method, first, the (a') process is carried out in the same manner as in Method III above, and a mesh-pattern transparent electromagnetic radiation shield layer ((A) layer) is formed. Then, (b') process is carried out in the same manner as in Method II and then a transparent near infrared cut layer ((B) layer) is formed.

Thereby the aimed transparent electromagnetic radiation shielding/near infrared cutting material is obtained.

When the transparent electromagnetic radiation shielding/near infrared cutting materials obtained by Method I-IV of the present invention are used for placement in a display, earth portions need to be provided. In such case, portions of the metallic layer (conductive portions) of the (A) layer or the (B) layer can be exposed by a conventional method (blasting, etc.).

### Examples

Next, the invention is explained in more detail with embodiments; however, these embodiments should not limit the scope of the invention.

### Example 1

A resist pattern (side long of a square: 180 µm, pattern interval: 20 µm and thickness: 5 µm) that is opposite to a grid pattern (square) was formed on a glass plate. After that, by ion plating (IP), three layers of IP tin oxide (black metal oxide layer: 0.1 µm)/IP copper (metallic layer: 1.0 µm)/IP tin oxide (black metal oxide layer: 0.1 µm) were formed on the surface including the resist pattern and the glass. Then, the formed product was soaked in a peeling solution to peel off and remove the resist (and the three layers formed thereon) to form a transparent electromagnetic radiation shield layer (grid-like pattern with line width of 20 µm and line interval of 180 µm) (liftoff method).

Further, by spattering (SP), a transparent near infrared cut layer composed of three layers of SP zinc sulfide (36 nm)/SP silver (27 nm)/SP zinc sulfide (37 nm) was formed on the entire surface of the glass plate (on the grid-like pattern of the electromagnetic radiation shield layer and the exposed portions of the glass plate) to fabricate a transparent electromagnetic radiation shielding/near infrared cutting material.

The transparent electromagnetic radiation shielding/near infrared cutting material exhibited high shielding performance of 70 dB (500 MHz), high near infrared cutting performance of 10 % expressed as a near infrared transmittance (90 % of cutting rate combining with a reflectance and an absorptance) and high transparency of 70 % expressed as visible light transmittance. This transparent electromagnetic radiation shielding/near infrared cutting material exhibited excellent clarity (high degree of blackness of the black layer and excellent uniformity were observed) and high long-term stability of shielding performance. Especially, remarkably high shielding performance was observed as a result of a synergistic effect with the electromagnetic radiation shield layer and the near infrared cut layer (having a certain degree of shielding performance).

### Example 2

A resist pattern (side long of square: 180 µm, pattern interval: 20 µm and thickness: 5 µm) that is opposite to a grid pattern (square) was formed on a glass plate. After that, by ion plating (IP), two layers of IP copper (metallic layer: 1.0 µm)/IP tin oxide (black metal oxide layer: 0.1 µm) were formed on the surface including the resist pattern and the glass. Then, the formed product was soaked in a peeling solution and the resist (and the two layers formed thereon) was peeled off and removed to form a transparent electromagnetic radiation shield layer (grid-like pattern having line width of 20 µm and line interval of 180 µm) (liftoff method).

Further, by ion plating (IP), a transparent infrared cut layer composed of six layers of titanium oxide (100 nm)/silicon dioxide (160 nm)/titanium oxide (100 nm)/silicon dioxide (160 nm)/titanium oxide (100 nm)/silicon dioxide (80 nm) was formed to fabricate a transparent electromagnetic radiation shielding/near infrared cutting material.

The transparent electromagnetic radiation shielding/near infrared cutting material exhibited high shielding performance of 60 dB (500 MHz), high near infrared cutting performance of 5 % expressed as a near infrared transmittance and high transparency of 75 % expressed as an optical transmittance. This transparent electromagnetic radiation shielding/near infrared cutting material exhibited excellent clarity (high degree of blackness of the black layer and excellent uniformity were observed) and high long-term stability of shielding performance. Especially, markedly high shielding performance was observed as a result of a synergistic effect with the electromagnetic radiation shield layer and the near infrared cut layer (having a certain degree of shielding performance).

### Example 3

By ion plating (IP), two layer of IP tin oxide (black metal oxide layer: 0.1 µm)/IP copper (metallic layer: 1.0 µm) were formed on a glass pate. Then, a grid-like pattern (line width: 20 µm, line interval: 180 µm and thickness: 5 µm) of an etching resist was formed on the two layers formed on the glass plate. The formed product was then soaked in etching solution (aqueous solution of 20 weight % of ferric chloride/1.75 weight % of hydrochloric acid) to remove the non-resist portions of the black metal oxide layer/metallic layer and peel off the resist pattern to form a transparent electromagnetic radiation shield layer (having the same pattern and line width/line interval as those of the resist pattern).

Further, on the entire surface of the glass plate (on the grid-like patterned electromagnetic radiation shield layer and the exposed portions of the glass plate), a transparent near infrared cut layer made of a polycarbonate resin coating (coating thickness: 10 µm) containing diimonium compound (coloring agent that absorbs near infrared rays) was formed to fabricate a transparent electromagnetic radiation shielding/near infrared cutting material.

The transparent electromagnetic radiation shielding/near infrared cutting material exhibited high shielding performance of 60 dB (500 MHz), high near infrared cutting performance of 10 % expressed as a near infrared transmittance and high transparency of 65 % expressed as a visible light transmittance. This transparent electromagnetic radiation shielding/near infrared cutting material exhibited excellent clarity (an adequately high degree of blackness of the black layer and excellent uniformity were observed) and markedly high long-term stability of the shielding performance.

### Example 4

On a glass plate, by spattering (SP), a transparent near infrared cut layer composed of three layers of SP zinc sulfide (36 nm)/SP silver (27 nm)/SP zinc sulfide (37 nm) was formed.

Then, a resist pattern (side long of a square: 180 µm, pattern interval: 20 µm and thickness: 5 µm) opposite to the grid-like pattern (square) was formed. On the resist pattern portions and the glass portions, by ion plating (IP), three layers of IP tin oxide (black metal oxide layer: 0.1 µm)/IP copper (metallic layer: 1.0 µm)/IP tin oxide (black metal oxide layer: 0.1 µm) were formed. Finally, the formed product was soaked in a peeling solution to peel off and remove the resist (and the three layers formed thereon) to form a transparent electromagnetic radiation shield layer (grid-like pattern with line width of 20 µm and line interval of 180 µm) and to form a transparent electromagnetic radiation shielding/near infrared cutting material.

The transparent electromagnetic radiation shielding/near infrared cutting material exhibited high shielding performance of 65 dB (500 MHz), high near infrared cutting performance of 10 % expressed as a near infrared transmittance, high transparency of 70 % expressed as a visible light transmittance and excellent clarity (an adequately high degree of blackness of the black layer and excellent uniformity were observed). The shielding performance and the long-term stability were poor compared to those in Example 1.

### Example 5

A coating solution was prepared by mixing an alcohol solution of polyvinylbutyral (PVB) (Denkabutyral #6000-C, product of Denki Kagaku Kogyo Kabushiki Kaisya) and an aqueous palladium (Pd) colloidal catalyst solution (OPC-80 Catalyst M, product of Okuno Chemical Industries Co., Ltd.) (Coating solution composition: PVB/catalyst solution/methanol/butanol weight ratio = 10/43/647/300, PD colloid = 2.9 weight % (as PdCl₂)).

The coating liquid was applied and dried by spin coater on a glass plate and then dried for 1 hour at 80 °C(coating thickness: 1 µm).

The coated (catalyst-containing) product was directly immersed for 1 hour in Cu plating solution (OPC-700M, product of Okuno Chemical Industries Co., Ltd.) (25 °C ) (Cu plating thickness: 1.0 µm). As a result, the surface of the coating on the glass plate exhibited a copper luster and the back surface of the coating (as viewed from the glass plate side) exhibited a deep black color.

The Cu plated product was coated with a positive etching photoresist (PMER P-DF40S, product of Tokyo Ohka Kogyo Co., Ltd.), prebaked, exposed (using a grid-like pattern mask) and developed to form a grid-like resist pattern (line width: 20 µm, line interval: 180 µm and thickness: 5 µm). These processes were conducted under the conditions recommended by the manufacturer.

The resist-patterned product was immersed in etching solution at a room temperature (aqueous solution of 20 weight % of ferric chloride/1.75 weight % of hydrochloric acid) for 1 minute to remove the non-resist portions of the copper plating and the blackened copper within the coating by etching. The resist pattern was then peeled off to produce a transparent electromagnetic radiation shield layer (having the same pattern and line width/line interval as those of the resist pattern).

Further, on the entire surface of the glass plate (on the grid-like patterned electromagnetic radiation shield layer and the exposed portions of the glass plate), a transparent near infrared cut layer was formed in the same manner as in Example 1 to fabricate a transparent electromagnetic radiation shielding/near infrared cutting material.

The transparent electromagnetic radiation shielding/near infrared cutting material exhibited high shielding performance of 70 dB (500 MHz), high near infrared cutting performance of 10 % expressed as a near infrared transmittance, high transparency of 70 % expressed as a visible light transmittance. This transparent electromagnetic radiation shielding/near infrared cutting material exhibited excellent clarity (an adequately high degree of blackness of the black layer and excellent uniformity were observed) and high long-term stability of the shielding performance. Especially, the shielding performance was remarkably high as a result of a synergistic effect of the electromagnetic radiation shield layer and the near infrared cut layer (having a certain degree of shielding performance). Clarity (degree of blackness of the black layer) was superior to that of Example 1.

### Example 6

A transparent electromagnetic radiation shield layer was formed on a glass plate in the same manner as in Example 5, then a transparent near infrared cut layer was formed on the entire surface of the glass plate (on the grid-like patterned electromagnetic radiation shield layer and the exposed portions of the glass plate) in the same manner as in Example 2 to fabricate a transparent electromagnetic radiation shielding/near infrared cutting material.

The transparent electromagnetic radiation shielding/near infrared cutting material exhibited high shielding performance of 60 dB (500 MHz), high near infrared cutting performance of 5 % expressed as a near infrared transmittance and high transparency of 75 % expressed as a visible light transmittance. This transparent electromagnetic radiation shielding/near infrared cutting material also exhibited excellent clarity (degree of blackness of the black layer) and markedly high long-term stability of the shielding performance.

### Example 7

A transparent electromagnetic radiation shield layer was formed on a glass plate in the same manner as in Example 5, then a transparent near infrared cut layer was formed on the entire surface of the glass plate (on the grid-like patterned electromagnetic radiation shield layer and the exposed portions of the glass plate) in the same manner as in Example 3 to fabricate a transparent electromagnetic radiation shielding/near infrared cutting material.

The transparent electromagnetic radiation shielding/near infrared cutting material exhibited high shielding performance of 60 dB (500 MHz), high near infrared cutting performance of 10 % expressed as a near infrared transmittance and high transparency of 65 % expressed as a visible light transmittance. This transparent electromagnetic radiation shielding/near infrared cutting material also exhibited excellent clarity (degree of blackness of the black layer) and markedly high long-term stability of the shielding performance.

### Example 8

A transparent near infrared cut layer was formed on a glass plate in the same manner as in Example 2, then a transparent electromagnetic radiation shield layer was formed on the surface of the transparent near infrared cut layer formed on the glass plate in the same manner as in Example 5 to fabricate a transparent electromagnetic radiation shielding/near infrared cutting material.

The transparent electromagnetic radiation shielding/near infrared cutting material exhibited high shielding performance of 60 dB (500 MHz), high near infrared cutting performance of 5 % expressed as a near infrared transmittance and high transparency of 75 % expressed as a visible light transmittance. This transparent electromagnetic radiation shielding/near infrared cutting material also exhibited excellent clarity (degree of blackness of the black layer). Long-term stability of the shielding performance was poor compared to Examples 1-3 and 5-7.

### Example 9

A black coating liquid was prepared by uniformly dispersing black pigment (iron oxide fine power; Tetsuguro 0023, product of Daido Chemical Industry Co., Ltd.) in an alcohol (ethanol) solution of polyvinylbutyral (PVB) (#6000-C, product of Denki Kagaku Kogyo, Co., Ltd.) (Coating solution composition: iron oxide/PVB/ethanol = 50/100/1850).

The coating liquid was applied to one surface of 12 µm electrolytic copper foil (CF T9 SV, product of Fukuda Metal Foil and Powder Co., Ltd.) and dried to obtain a first black resin layer (10 µm). The coated surface was laminated to a glass plate using an acrylic adhesive to obtain a laminated article.

The laminated article (copper foil side) was coated with a resist (black photoresist; NPR-60/5CER, product of Japan Polytech Co., Ltd.) used for patterning the first black layer and a metallic layer, prebaked, exposed, developed, photobaked to form a resist pattern (a second black resin layer; grid-like pattern having thickness of 15 µm, line width of 20 µm and line interval of 180 µm).

The resist-patterned product was immersed in etching solution at a room temperature (aqueous solution of 20 weight % of ferric chloride/1.75 weight % of hydrochloric acid) to dissolve and remove the non-resist portions of the copper foil. Then, the first black resin layer was removed by sandblasting (thickness of the second black resin layer after blasting: 10 µm) to produce a transparent electromagnetic radiation shield layer (having the same pattern and line width/line interval as those of the resist pattern).

Further, on the entire surface of the glass plate (on the grid-like patterned electromagnetic radiation shield layer and the exposed portions of the glass plate), a transparent near infrared cut layer was formed in the same manner as in Example 3 to fabricate a transparent electromagnetic radiation shielding/near infrared cutting material.

The transparent electromagnetic radiation shielding/near infrared cutting material exhibited high shielding performance of 60 dB (500 MHz), high near infrared cutting performance of 10 % expressed as a near infrared transmittance, high transparency of 65 % expressed as a visible light transmittance. This transparent electromagnetic radiation shielding/near infrared cutting material exhibited excellent clarity (an adequately high degree of blackness of the black layer and excellent uniformity were observed) and markedly high long-term stability of the shielding performance.

### Comparative Example 1

A resist pattern (side long of a square: 180 µm, pattern interval: 20 µm and thickness: 5 µm) opposite to the grid-like pattern (square) was formed on a glass plate. On the resist pattern portions and the glass portions, by ion plating (IP), three layers of IP tin oxide (black metal oxide layer of 0.1 µm)/IP copper (metallic layer of 1.0 µm)/IP tin oxide (black metal oxide layer of 0.1 µm) were formed. Then, this formed product was soaked in a peeling solution to peel off and remove the resist (and the three layers formed thereon) to form a transparent electromagnetic radiation shield layer (grid-like pattern with line width of 20 µm and line interval of 180 µm) (liftoff method).

Although the transparent electromagnetic radiation shielding material exhibited shielding performance of 60 dB (500 MHz), transparency of 75 % and good clarity (an adequately high degree of blackness of the black layer and good uniformity were observed), little near infrared cutting performance was observed and long-term stability of the electromagnetic radiation shielding performance was poor compared to that of Example 1.

### Comparative Example 2

On a glass plate, by spattering (SP), a transparent near infrared cut layer composed of three layers of SP zinc sulfide (36 nm)/SP silver (27 nm)/SP zinc sulfide (37 nm) was formed.

Although the transparent near infrared cutting material exhibited near infrared cutting performance of 10 % expressed as a near infrared transmittance and transparency of 80 % expressed as a visible light transmittance, shielding performance was as far low as 30 dB (500 MHz) compared to that of Example 1 and Comparative Example 1. No clarity and no long-term stability were observed.

### Comparative Example 3

A resist pattern (side long of a square: 180 µm, pattern interval: 20 µm and thickness: 5 µm) opposite to the grid-like pattern (square) was formed on a glass plate. On the resist pattern portions and the glass portions, by ion plating (IP), three layers of IP tin oxide (black metal oxide layer of 0.1 µm)/IP copper (metallic layer of 1.0 µm)/IP tin oxide (black metal oxide layer of 0.1 µm) were formed. Then, this formed product was soaked in a peeling solution to peel off and remove the resist (and the three layers formed thereon) to form a transparent electromagnetic radiation shield layer (grid-like pattern with line width of 20 µm and line interval of 180 µm) (liftoff method).

Further, on the opposite side of the electromagnetic radiation shield layer, by spattering (SP), a transparent near infrared cut layer composed of three layers of SP zinc sulfide (36 nm)/SP silver (27 nm)/SP zinc sulfide (37 nm) was formed to fabricate a transparent electromagnetic radiation shielding/near infrared cutting material.

Although the transparent electromagnetic radiation shielding/near infrared cutting material exhibited good shielding performance of 60 dB (500 MHz), near infrared cutting performance of 10 % expressed as a near infrared transmittance, transparency of 70 % and clarity (an adequately high degree of blackness of the black layer and good uniformity were observed), no synergistic effect of shielding performance as observed in Example 1 was observed and long-term stability of the electromagnetic radiation shielding performance was inferior to that of Example 1.

### Comparative Example 4

A transparent conductive thin film (500 nm; electromagnetic radiation shield layer) of ITO (indium tin oxide) was formed on a glass plate by ion plating (IP) and then, a transparent near infrared cut layer was formed on the surface of the transparent conductive thin film formed on the glass plate in the same manner as in Example 2 to fabricate a transparent electromagnetic radiation shielding/near infrared cutting material.

Although the transparent electromagnetic radiation shielding/near infrared cutting material exhibited near infrared cutting performance of 10 % expressed as a near infrared transmittance and transparency of 70 % expressed as a visible light transmittance, shielding performance was an extremely low at 15 dB (500 MHz) and clarity was bad. Long-term stability of the shielding performance was high; however, the material could not be used for displays such as PDP since shielding performance itself was low.

### Comparative Example 5

A transparent conductive thin film was formed on a glass plate in the same manner as in Comparative Example 4, and then a print pattern (grid-like pattern with line width of 1 mm, line interval of 7 mm and thickness of 20 µm) made of silver paste was formed on the surface of the transparent conductive thin film formed on the glass plate by screen printing to produce a transparent electromagnetic radiation shielding material.

Although the transparent electromagnetic radiation shielding material exhibited transparency of 65 % expressed as a visible light transmittance, shielding performance was as low as 15 dB (500 MHz) and near infrared cutting performance expressed as a near infrared transmittance was as low as 70 % (30 % expressed as cutting rate). Further, clarity and long-term stability of the shielding performance were bad. Since shielding performance and near infrared cutting performance themselves were low, the material could not be used for use of displays such as PDP.

The present invention provides the following advantageous effects:
(1) By laminating at least a transparent electromagnetic radiation shield layer and a transparent near infrared cut layer with a contact therebetween, the number of layer (the number of material) is significantly reduced compared to the case laminating transparent electromagnetic radiation shield layer and a transparent near infrared cut layer via an adhesive layer, so that a thin, light and highly transparent material can be easily produced. Further, material cost is significantly reduced and high yield in manufacturing is achieved and production cost becomes low.
(2) Particularly when forming a near infrared cut layer on a transparent electromagnetic radiation shield layer (containing a metallic layer) by dry plating, electromagnetic radiation shielding performance is dramatically improved.
(3) When laminating a near infrared cut layer on a transparent electromagnetic radiation shield layer, long-term stability of electromagnetic radiation shielding performance is improved as a result of a protective effect of the transparent near infrared cut layer.
(4) Since the transparent electromagnetic radiation shield layer has a high flexibility in pattern designing, high electromagnetic radiation shielding performance and high transparency (visible light transmittance) can be compatible (they can hardly be compatible with fiber mesh articles and transparent conductive thin films) and viewing angle is markedly wide. An earth lead line can easily and securely be connected by simply providing frame portions when designing patterns (If fiber mesh articles are used, such step is carried out in an aftertreatment such as frame printing of conductive paste, lamination of copper foil tape, etc. so that it is disadvantageous in view of manufacturing process and connection). Further, Moire fringes can be easily eliminated, and clarity is outstandingly high due to existence of a black layer.
(5) With the transparent near infrared cut layer, high near infrared cut layer and high visible light transmittance can be simultaneously obtained by optimization of composition, structure and thickness of a coating. Further, by providing a color adjustment layer, desired color tones of material can be obtained.
(6) When a material that is constituted as a continuous web (roll type) is used for a transparent base material, required (various) size of material can be cut out and can be laminated to a transparent base material having a rigidity or can be directly laminated to displays, etc. in desired use. Accordingly, yield is improved because inclusion of defective portions can be avoided. When directly laminated to displays, for example, image quality becomes clear (for the electromagnetic radiation shield layer having a mesh pattern, image becomes blurred with a distance from a display). Shielding a display is also possible when successfully being laminated.

It is to be understood that although the present invention has been described with regard to preferred embodiments thereof, various other embodiments and variants may occur to those skilled in the art, which are within the scope and spirit of the invention, and such other embodiments and variants are intended to be covered by the following claims.

## Claims

1. A transparent electromagnetic radiation shielding/near infrared cutting material in which:
at least (A) an identical and matched mesh-pattern transparent electromagnetic radiation shield layer having a black layer/metallic layer or a metallic layer/black layer or a black layer/metallic layer/black layer; and
(B) a transparent near infrared cut layer are laminated with a contact therebetween on a transparent base material.

2. The transparent electromagnetic radiation shielding/near infrared cutting material according to claim 1, wherein said transparent electromagnetic radiation shield layer and said transparent near infrared cut layer are laminated in order with a contact therebetween on the same surface as that of the transparent base material by dry plating.

3. The transparent electromagnetic radiation shielding/near infrared cutting material according to claim 1, wherein said transparent base material is tempered glass, olefine-maleimide copolymer or norbornene resins.

4. The transparent electromagnetic radiation shielding/near infrared cutting material according to claim 1, wherein aperture width (line interval) of the mesh pattern of said transparent electromagnetic radiation shield layer is less than 7 mm and line width is less than 1 mm.

5. The transparent electromagnetic radiation shielding/near infrared cutting material according to claim 1, wherein said transparent near infrared cut layer is a laminated layer, said laminated layer being so constituted that a transparent metal oxide layer or a transparent metal sulfide layer and a metallic thin film layer are laminated one after the other in order so that the outer most layer is the transparent metal oxide layer or the transparent metal sulfide layer.

6. The transparent electromagnetic radiation shielding/near infrared cutting material according to claim 5, wherein said metallic thin film layer of the transparent near infrared cut layer is composed of gold, silver, copper or an amorphous of such metals.

7. The transparent electromagnetic radiation shielding/near infrared cutting material according to claim 1, wherein said transparent near infrared cut layer is so constituted that two types of transparent inorganic layers having a different refractive index are laminated one after the other.

8. The transparent electromagnetic radiation shielding/near infrared cutting material according to claim 7, wherein said two types of transparent inorganic layers having a different refractive index of the transparent near infrared cut layer is a combination of silicon dioxide layer and titanium oxide layer.

9. The transparent electromagnetic radiation shielding/near infrared cutting material according to claim 2, wherein said transparent base material is tempered glass, olefine-maleimide copolymer or norbornene resins.

10. The transparent electromagnetic radiation shielding/near infrared cutting material according to claim 2, wherein aperture width (line interval) of the mesh pattern of said transparent electromagnetic radiation shield layer is less than 7 mm and line width is less than 1 mm.

11. The transparent electromagnetic radiation shielding/near infrared cutting material according to claim 2, wherein said transparent near infrared cut layer is a laminated layer, said laminated layer being so constituted that a transparent metal oxide layer or a transparent metal sulfide layer and a metallic thin film layer are laminated one after the other in order so that the outer most layer is the transparent metal oxide layer or the transparent metal sulfide layer.

12. The transparent electromagnetic radiation shielding/near infrared cutting material according to claim 11, wherein said metallic thin film layer of the transparent near infrared cut layer is composed of gold, silver, copper or an amorphous of such metals.

13. The transparent electromagnetic radiation shielding/near infrared cutting material according to claim 2, wherein said transparent near infrared cut layer is so constituted that two types of transparent inorganic layers having a different refractive index are laminated one after the other.

14. The transparent electromagnetic radiation shielding/near infrared cutting material according to claim 13, wherein said two types of transparent inorganic layers having a different refractive index of the transparent near infrared cut layer is a combination of silicon dioxide layer and titanium oxide layer.

15. A method of producing a transparent electromagnetic radiation shielding/near infrared cutting material comprising the steps of:
forming a black layer/metallic layer or a metallic layer/black layer or a black layer/metallic layer/black layer on a transparent base material by dry plating;
forming a mesh-like resist pattern layer on said black layer/metallic layer or metallic layer/black layer or black layer/metallic layer/black layer;
conducting sandblasting and/or etching treatment using said mesh-like resist pattern layer as a protection film to form a mesh pattern of said black layer/metallic layer or metallic layer/black layer or black layer/metallic layer/black layer, the mesh pattern being matched to that of the resist pattern layer;
peeling off the resist pattern layer; and
laminating a transparent metal oxide layer or a transparent metal sulfide layer and a metallic thin film layer by dry plating one after the other in order so that the outer most layer is the transparent metal oxide layer or the transparent metal sulfide layer.

16. A method of producing a transparent electromagnetic radiation shielding/near infrared cutting material comprising the steps of:
forming a black layer/metallic layer or a metallic layer/black layer or a black layer/metallic layer/black layer on a transparent base material by dry plating;
forming a mesh-like resist pattern layer on said black layer/metallic layer or metallic layer/black layer or black layer/metallic layer/black layer;
conducting sandblasting and/or etching treatment using said mesh-like resist pattern layer as a protection film to form a mesh pattern of said black layer/metallic layer or metallic layer/black layer or black layer/metallic layer/black layer, the mesh pattern being matched to that of the resist pattern layer;
peeling off the resist pattern layer; and
laminating two types of transparent inorganic layers having a different refractive index one after the other.

17. A method of producing a transparent electromagnetic radiation shielding/near infrared cutting material comprising the steps of:
forming a resist pattern layer on a transparent base material so as mesh-like portions of the transparent base material to be exposed;
forming a black layer/metallic layer or a metallic layer/black layer or a black layer/metallic layer/black layer on the resist pattern layer and the mesh-like portions of the transparent base material by dry plating;
peeling off the resist pattern layer so that only portions of the black layer/metallic layer or metallic layer/black layer or black layer/metallic layer/black layer formed on the surface of the resist layer are removed; and
laminating a transparent metal oxide layer or a transparent metal sulfide layer and a metallic thin film layer one after the other in order by dry plating so that the outer most layer is the transparent metal oxide layer or the transparent metal sulfide layer.

18. A method of producing a transparent electromagnetic radiation shielding/near infrared cutting material comprising the steps of:
forming a resist pattern layer on a transparent base material so as mesh-like portions of the transparent base material to be exposed;
forming a black layer/metallic layer or a metallic layer/black layer or a black layer/metallic layer/black layer on the resist pattern layer and the mesh-like portions of the transparent base material by dry plating;
peeling off the resist pattern layer so that only portions of the black layer/metallic layer or metallic layer/black layer or black layer/metallic layer/black layer formed on the surface of the resist layer are removed; and
laminating two types of transparent inorganic layers having a different refractive index one after the other.
